# EUROPEAN PATENT APPLICATION

(11) **EP 4 040 928 A1**
(43) Date of publication of application: **10.08.2022**
(21) Application number: 20882733.7
(22) Date of filing: 29.10.2020
(51) Int. Cl.: H05K 5/02

(54) **SHELL ASSEMBLY AND PREPARATION METHOD THEREFOR, AND ELECTRONIC DEVICE**

(30) Priority: 01.11.2019 CN 201911061864
(71) Applicant: GUANGDONG OPPO MOBILE TELECOMMUNICATIONS CORP., LTD., Dongguan, Guangdong 523860 (CN)
(72) Inventor: LI, Cong, Dongguan, Guangdong 523860 (CN)
(74) Representative: Ipside
(86) International application number: PCT/CN2020/124756
(87) International publication number: WO 2021/083266

(57) **Abstract**

Provided are a shell assembly and a preparation method therefore, and an electronic device. The shell assembly comprises a glass substrate, wherein the glass substrate has a first surface and a second surface which are opposite each other, the first surface has a first micron-sized three-dimensional texture, the second surface has a second micron-sized three-dimensional texture, and an orthographic projection of the first three-dimensional texture in a vertical direction does not completely overlap with an orthographic projection of the second three-dimensional texture in the vertical direction, such that reflected lights of the first three-dimensional texture interferes with reflected lights of the second three-dimensional texture. In the shell assembly, a double-layer three-dimensional texture is directly formed on two opposite surfaces of glass, which improves the manufacturing yield, is not prone to deformation, and solves problems in terms of decoration reliability and manufacturing yield well. In addition, by means of the optical interference of the double-layer texture, the shell assembly can form a special moire appearance to present a more dazzling and three-dimensional appearance decorative effect, which can greatly improve the attractiveness and competitiveness of products.

## Description

### PRIORITY INFORMATION

The present disclosure claims priority to Chinese Patent Application No. 201911061864.3 filed with China National Intellectual Property Administration on November 1, 2019, the contents of which are herein incorporated by reference in their entireties.

### TECHNICAL FIELD

The present disclosure relates to the technical field of electronic devices, and more specifically, to a shell assembly and a preparation method therefor, and an electronic device.

### BACKGROUND

In related art, a UV-gel texture layer is usually formed on a PET film by UV transferring, in order to show beautiful textures on the appearance of glass. During long-term use, the PET film is liable to be aged and deformed, which makes the UV-gel texture layer attached on the PET film crack, and the texture effect thereof becomes weak. In order to avoid crack brought by the deformation of the PET, someone raises a means of directly spraying UV gel on an inner surface of glass, then rolling the UV gel by a mold with textures, and performing an ultraviolet exposure to form the UV-gel texture layer. However, the UV-gel texture layer, which is formed on the surface of glass by the exposure means, is liable to arise broken line(s) or bubble(s), thus the yield thereof is low.

Therefore, it is necessary to improve the technology of appearance decoration for the current glass shell.

### SUMMARY OF THE DISCLOSURE

The present disclosure aims to at least solve one of the technical problems in the related art to some degree. Thereby, the present disclosure provides a shell assembly with special Moire texture appearance, which is formed by optical interference of double layer three-dimensional textures directly formed on two opposite surfaces of glass.

According to one aspect of the present disclosure, the present disclosure provides a shell assembly. In an embodiment of the present disclosure, the shell assembly includes: a glass substrate, the glass substrate has a first surface and a second surface opposite to each other. The first surface has first three-dimensional textures, the second surface has second three-dimensional textures. Orthographic projections the first three-dimensional textures in a vertical direction are not fully overlapped with orthographic projections of the second three-dimensional textures in the vertical direction, making lights reflected by the first three-dimensional textures and lights reflected by the second three-dimensional textures interfere with each other. In the shell assembly, double layers of three-dimensional textures are directly formed on two opposite surfaces of the glass without spraying the UV gel, thus the production yield is improved. Further, the three-dimensional textures formed directly on the surfaces of the glass have been fixed thereon, therefore it is not liable to deform, which well solves the problem of reliability of decoration and achieves the production yield. Further, the optical interference of the double layer textures may make the shell assembly form a special Moire texture appearance, which renders more dazzle and more stereoscopic appearance decoration effect, thereby greatly improving the appearance attraction and the competition of the product.

According to another aspect of the present disclosure, the present disclosure provides a preparation method for a shell assembly. In an embodiment of the present disclosure, the method includes: forming a dry film with preset patterns on two opposite surfaces of a glass, to obtain a to-be-etched glass; immerging the to-be-etched glass into an etching liquid for a preset time to obtain a glass substrate, wherein the glass substrate comprises a first surface and a second surface opposite to each other, the first surface has first three-dimensional textures in micron level formed by etching, the second surface has second three-dimensional textures in micron level formed by etching, orthographic projections of the first three-dimensional textures in a vertical direction and orthographic projections of the second three-dimensional textures in the vertical direction are not fully overlapped with each other, making lights reflected by the first three-dimensional textures and lights reflected by the second three-dimensional textures are interfere with each other; and removing the dry film on the glass substrate. By this method, the shell assembly with the double layer three-dimensional textures may be manufactured and obtained fast and efficiently. The manufacturing process is simple, the operation is easy, and the production yield is high. Further, the obtained shell assembly may form a special Moire texture appearance, which renders more dazzle and more stereoscopic appearance decoration effect. In the mean time, it's not easy to deform during long-time use.

According to a third aspect of the present disclosure, the present disclosure provides an electronic device. In some embodiments of the present disclosure, the electronic device includes: the foregoing shell assembly, wherein the shell assembly is configured to define an accommodating space; and a display screen disposed in the accommodating space. The electronic device has double layer three-dimensional textures, and is able to render a special Moire texture appearance and to render a decoration effect having more dazzle and stereoscopic appearance effect. The electronic device is not liable to deform in long term usage, and has a longer service life.

### BRIEF DESCRIPTION OF THE DRAWINGS

Figure 1 is a schematic diagram of a structure of a shell assembly according to an embodiment of the present disclosure.
Figure 2 is a schematic diagram of a structure of the shell assembly according to another embodiment of the present disclosure.
Figure 3 is a schematic diagram of an orthographic projection of a first surface of the glass substrate in a vertical direction according to an embodiment of the present disclosure.
Figure 4 is a schematic diagram of an orthographic projection of the first surface of the glass substrate in the vertical direction according to another embodiment of the present disclosure.
Figure 5 is a schematic diagram of an orthographic projection of the first surface of the glass substrate in the vertical direction according to another embodiment of the present disclosure.
Figure 6 is a schematic diagram of a structure of the shell assembly according to another embodiment of the present disclosure.
Figure 7 is a schematic diagram of a structure of the electronic device according to an embodiment of the present disclosure.
Figure 8 is a photograph of a glass shell obtained from embodiment 1 of the present disclosure.

### DETAILED DESCRIPTION

The present disclosure is described below in detail. The embodiments described below are exemplary only to explain the present disclosure, and not to be understood as a limitation to the present disclosure. The embodiments without any indication of detailed technologies or conditions, technologies or conditions described in the documentation in the field or description of the product are followed to operate. Used reagents or instruments without manufacturer are all common products obtained from markets.

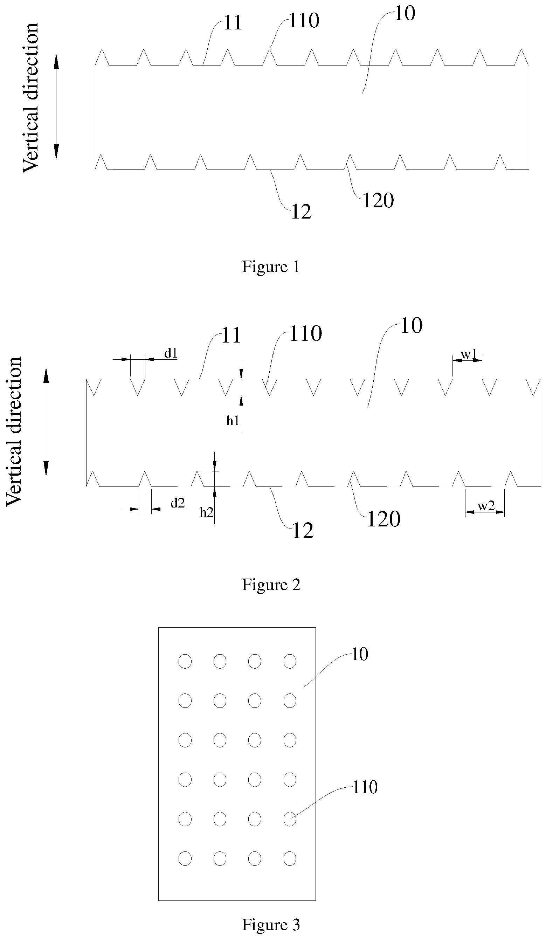

According to one aspect of the present disclosure, the present disclosure provides a shell assembly. In some embodiments of the present disclosure, referring to Figure 1, the shell assembly includes a glass substrate 10. The glass substrate has a first surface 11 and a second surface 12 opposite to each other, the first surface has first three-dimensional textures 110 in micron level, the second surface has second three-dimensional textures 120 in micron level. Orthographic projections of the first three-dimensional textures 110 in a vertical direction and orthographic projections of the second three-dimensional textures 120 in the vertical direction are not totally overlapped, so that lights reflected by the first three-dimensional textures 110 and lights reflected by the second three-dimensional textures 120 may interfere with each other. In the shell assembly, double layers of the three-dimensional textures are directly formed on two opposite surfaces of the glass, without spraying UV gel, thus the production yield is improved. Further, the three-dimensional textures formed directly on the surfaces of glass have been fixed thereon, therefore it is not liable to deform, which well solves the problem of reliability of decoration and achieves a high production yield. Furthermore, the optical interference of the double layer textures may make the shell assembly form a special Moire texture appearance, which renders more dazzle and stereoscopic appearance decoration effect, thereby greatly improving the appearance attraction and the competition of the product.

In detail, according to the interference principal, the interference is a phenomena of forming new waves by spatially overlaying two or more columns of waves. For the shell assembly of the present disclosure, when lights are incident on the three-dimensional textures of the shell assembly, reflected lights at different positions may have light distances different from each other since the three-dimensional textures cause the surface uneven. Thus, the reflected lights will interfere with each other. Therefore, the reflected lights at different positions of the surface with the first three-dimensional textures will interfere with each other, and the reflected lights at different positions of the surface with the second three-dimensional textures will also interfere with each other. Meanwhile, the reflected lights reflected by the first three-dimensional textures and the reflected lights reflected by the second three-dimensional textures will interfere with each other. Under the interference effect of the double layer three-dimensional textures, an outer surface of the shell may present bright and dark strips produced by interference, that is, Moire textures, which form a special appearance effect. The detailed shapes and arranging ways of the Moire textures may be adjusted according to the shapes and arranging ways of the first three-dimensional textures and the second three-dimensional textures.

It is to be noted that, "first three-dimensional textures in micron level" and "second three-dimensional textures in micron level" mean that the line widths and line distances of the first three-dimensional textures and the second three-dimensional textures are both in the micron level, that is, in the range of 1 to 1000 microns. If the line widths and line distances are too small, it is not easy to process on one hand, and on the other hand, the light-split phenomena may occur when the lights are incident on the textures with too small size, therefore it is unable to show the Moire texture appearance under the condition of the textures in micron level. However, the interference condition could not be satisfied if the line widths and line distances are oversized, thereby not arising the Moire texture appearance.

In some embodiments, the glass substrate may be any glass suitable for the shell assembly of the electronic device. The glass, for example, may be silicate glass (specifically such as, quartz glass, high silica glass, calcium sodium glass, aluminosilicate glass, borosilicate glass, etc.), borate glass, phosphate glass, etc. The thickness of the glass substrate may be 0.5-8 mm, specifically such as 0.5 mm, 0.6 mm, 0.7 mm, 0.8 mm, 0.9 mm, 1 mm, 2 mm, 3 mm, 4 mm, 5 mm, 6 mm, 7 mm, 8 mm, etc. Besides, a detailed structure of the glass substrate may also be adopted according to an actual need. For example, the glass substrate may be planar glass, 2.5D glass, or 3D glass.

In some specific embodiments, referring to Figure 2, the first three-dimensional textures 110 and the second three-dimensional textures 120 may both be recessed toward an inside of the glass substrate 10. Thus, a good Moire texture apparatus can be guaranteed, while they may be conveniently manufactured by the etching technology, and edges and corners of the textures are recessed inwardly, which are not liable to be damaged and destroyed.

According to the embodiments of the present disclosure, detailed shapes, distribution locations, and sizes of the first three-dimensional textures and the second three-dimensional textures may be adjusted according to the desired appearance effect. In some specific embodiments, the line widths d1 of the first three-dimensional textures 110 (i.e. widths of the three-dimensional textures) and line widths d2 of the second three-dimensional textures 120 are 1-100 micron(s) respectively (in specific, the values may be 100 microns, 80 microns, 50 microns, 40 microns, 30 microns, 20 microns, 15 microns, 10 microns, 9 microns, 8 microns, 7 microns, 6 microns, 5 microns, 4 microns, 3 microns, 2 microns, 1 micron, or the like). In some specific embodiments, line distances w1 of the first three-dimensional textures 110 and line distances w2 of the second three-dimensional textures 120 are 1-150 micron(s) (in specific, the values may be 150 microns, 140 microns, 130 microns, 120 microns, 110 microns, 100 microns, 50 microns, 20 microns, 10 microns, 5 microns, 1 micron, or the like). In some specific embodiment, texture depths h1 of the first three-dimensional textures 110 and texture depths h2 of the second three-dimensional textures 120 are 1-100 micron(s) respectively (in specific, the values may be 100 microns, 80 microns, 50 microns, 40 microns, 30 microns, 20 microns, 15 microns, 10 microns, 9 microns, 8 microns, 7 microns, 6 microns, 5 microns, 4 microns, 3 microns, 2 microns, 1 micron, or the like). In the above ranges of line widths, line distances and depths, the double layer three-dimensional textures may make the reflected lights interfere with each other, so as to render the special Moire texture appearance, with more tridimensional and splendid appearance, and better decoration effect.

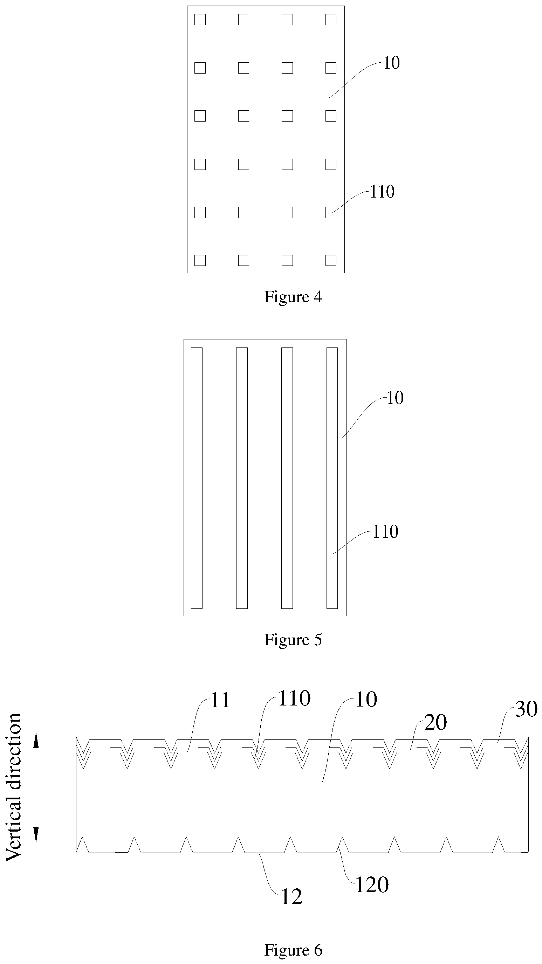

In some specific embodiments, shapes of the orthographic projections of the first three-dimensional textures 110 and the second three-dimensional textures 120 in the vertical direction are independent from each other, and may be any one of geometric shapes or irregular shapes. In detail, the geometric shapes may include at least one of circle (referring to Figure 3, illustrated as the first three-dimensional textures), polygon (specifically may be triangle, quadrangle, pentagon, hexagon etc.) (referring to Figures 4 and 5, orthographic projections of the first three-dimensional textures being illustrated as quadrangle), arch shape, or multi-arc shape. The irregular shapes may be flexibly set according to the appearance effect required to present, which would not be described herein.

In some specific embodiments, the orthographic projections of the first three-dimensional textures and the orthographic projections of the second three-dimensional textures are not totally overlapped. In specific, the first three-dimensional textures and the second three-dimensional textures may be different from each other in shape, size, or arrangement manner. For example, the first three-dimensional textures are a plurality of parallel strip textures, and the second three-dimensional textures are a plurality of dot textures arranged in an array; alternatively, the first three-dimensional textures and the second three-dimensional textures are both a plurality of parallel strip textures, but with different line widths and different line distances; alternatively, the first three-dimensional textures and the second three-dimensional textures are both a plurality of parallel strip textures in shape and size, however, they intersect with each other, for example perpendicular to each other, or crossed with an angle of 45 degrees, etc.

In some embodiments, referring to Figure 6, the shell assembly may further include: a coating layer 20 disposed on the first surface; a cover-bottom ink layer 30 disposed on a surface of the coating layer 20 away from the glass substrate 10. Thus, a combination of the coating layer and the cover-bottom ink layer makes the shell assembly full of brilliant colors. Further, the optical interference effect of the double layer three-dimensional textures may make the shell assembly present brilliant and stereoscopic appearance effect.

In some specific embodiments, the coating layer may be of single-layer structure, and also may be of multi-layer structure. In some specific embodiments, the material of the coating layer may be at least one of silicon dioxide, titanium dioxide, niobium pentoxide. For example, the material of the coating layer may be multi-layer structure with titanium dioxide and silicon dioxide alternatively disposed. The cover-bottom ink layer may be an ink layer with a preset color. In some specific embodiments, the cover-bottom ink layer may be a black ink layer, to achieve a better shading effect, and a better-looking appearance effect. In specific, the cover-bottom ink layer may be of sing-layer structure, and also may be of multi-layer structure. The specific ingredient and thickness of each ink layer may be same or different with each other. For example, the specific ingredient of the ink may be common ink used in the shell assembly of the electronic device, and the thickness thereof may be 10-15 microns. When the cover-bottom ink layer is of multi-layer structure, it may be formed by coating the same ink repeatedly, specifically, it may be formed by coating the ink for 2-3 times, with the thickness of 3-5 microns for each coating.

In some specific embodiments, the coating layer and the glass substrate have different refractive indexes. Therefore, it may achieve a clearer border between the glass substrate and the coating layer, a stronger texture effect, and a better optical interference effect generated by the double layer three-dimensional textures, thereby obtaining a more splendid and stereoscopic appearance effect. It may be understood that, the larger the difference value between the refractive indexes of the coating layer and the glass substrate, the clearer the border between the coating layer and the glass substrate and the stronger the interference effect generated by the double layer three-dimensional textures. In some embodiments, the difference value between the refractive indexes of the coating layer and the glass substrate may be equal to or greater than 0.5, for example, 0.5, 0.6,0.7, 0.8, 0.9, 1 etc. Therefore, the appearance effect of the shell assembly is more splendid and stereoscopic, and the decoration effect is better.

According to another aspect of the present disclosure, the present disclosure provides a preparation method for a shell assembly. According to the embodiments of the present disclosure, the method includes: forming a dry film with preset patterns on two opposite surfaces of a glass, to obtain a to-be-etched glass; immerging the to-be-etched glass into an etching liquid for a preset time to obtain a glass substrate, the glass substrate having a first surface and a second surface opposite to each other, the first surface having the first three-dimensional textures in micron level formed by etching, the second surface having the second three-dimensional textures in micron level formed by etching, the orthographic projection of the first three-dimensional textures in the vertical direction and the orthographic projection of the second three-dimensional textures in the vertical direction being not totally overlapped with each other, and lights reflected by the first three-dimensional textures and lights reflected by the second three-dimensional textures interfering with each other; and removing the dry film on the glass substrate. By this method, the shell assembly with the double layer three-dimensional textures may be manufactured and obtained fast and efficiently. The manufacturing process is simple, the operation is easy, and the production yield is high. In addition, the obtained shell assembly may form a special Moire texture appearance, which renders more dazzle and stereoscopic appearance decoration effect. In the mean time, it's not easy to deform during long-time use. It may be understood that this method may be used to manufacture the foregoing shell assembly.

In some specific embodiments, forming a dry film with preset patterns on two opposite surfaces of a glass may include: providing a whole layer of dry film, overlapping the whole layer of dry film with a film roll with preset patterns, and exposing and developing them, to obtain exposure areas and unexposed areas; removing the non-exposure areas of the dry film, to obtain the dry film with the preset patterns; and attaching the dry film with the preset patterns on the two opposite surfaces of the glass. It may be understood that, the whole layer of dry film is formed on two opposite surfaces of the glass before the whole layer of dry film is overlapped with the film roll. In specific, the dry film may be formed by spraying directly on the surfaces of the glass; also the dry film may be pre-manufactured and further attached to the surfaces of the glass. In some embodiments, the film roll may be overlapped with the whole layer of dry film to form an overlapped product, then the overlapped product is attached to two opposite surfaces on the glass, and then exposure and other subsequent operations are performed. The film roll with preset patterns may be manufactured by configuring a layout on computer, so the film roll with preset patterns has fine textures. It is to be noted that, the dry film on two opposite surfaces of the glass have different preset patterns, in order to guarantee the interference effect of the double layer three-dimensional textures.

It may be understood that the dry film mainly has the function of protecting glass, in specific, the dry film may protect a portion of the glass covered thereby from being etched in the subsequent operations. The dry film may resist attack of the etching liquid for a long time without being peeled off or melted. According to the forgoing usage requirement, the dry film may be a photosensitive acid-resistant film. Specifically, the dry film may be a polymer thin film, may be made of polyimide, liquid crystal polymer or polyethylene naphthalate thin film, which may perform cross-linking and curing when exposed to ultraviolet lights. After being covered with the film roll, the dry film may be further exposed directly to the ultraviolet lights. A portion of the dry film exposed to the lights is cured, and other portions of the dry film which are not exposed to the lights are not cured. The photosensitive film which is not cured may be removed by developing. For example, a flat spray line may be used for developing, to remove the non-exposure area of the dry film. The developing liquid may be a sodium carbonate solution with a mass concentration of 0.5% to 1%, so as to form preset patterns on the dry film corresponding to the film roll with preset patterns.

In some specific embodiments, after the dry film with preset patterns is formed on the glass, the to-be-etched glass may be immerged into the etching liquid to be etched, so as to form the three-dimensional textures at a position not covered by the dry film. In specific, the etching liquid adopted may be a hydrofluoric solution with a mass concentration of 5% to 10%. Therefore, the etching speed is fast, the etching accuracy is good, the obtained three-dimensional textures have smooth surfaces and high accuracy, and an appearance effect of the shell assembly is better. It could be understood that the etching period may be adjusted according to the sizes of the three-dimensional textures, the etching speed of the etching liquid, and the like. In some specific embodiments, the etching period (i.e. the foregoing preset time) may be 1-10 minutes, specifically such as 1 minute, 2 minutes, 3 minutes, 4 minutes, 5 minutes, 6 minutes, 7 minutes, 8 minutes, 9 minutes, 10 minutes, or the like.

In some specific embodiments, the glass substrate may be cleaned after etching, to remove the etching liquid left on the surfaces of the glass. In specific, water may be adopted to clean the glass substrate, or ultrasonic cleaning may be adopted to clean the glass substrate. Then the cleaned glass substrate is dried for convenience of further operations.

In some specific embodiments, the operation of removing the dry film with preset patterns from the glass substrate is not specially limited, as long as the dry film can be effectively removed, and the glass substrate would not be damaged. In some specific embodiments, de-plating technology may be adopted to remove the dry film with preset patterns. The specific process and parameters may refer to the conventional technology, which is not described here in detail.

In some specific embodiments, the method further includes: forming a coating layer on the first surface; and forming a cover-bottom ink layer on a surface of the coating layer far away from the glass substrate.

In specific, the coating layer may be formed by a method of physical vapor deposition, chemical vapor deposition, or the like. The cover-bottom ink layer may be formed by a process such as screen printing, coating, printing, presswork, or the like. The detailed operations and parameters may refer to the conventional technology, which will not be described herein.

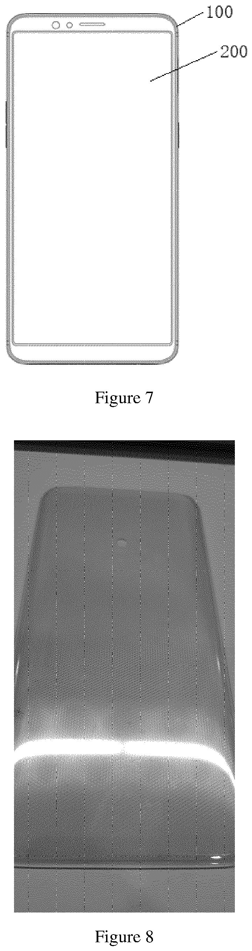

In a third aspect of the present disclosure, the present disclosure provides an electronic device. According to some embodiments of the present disclosure, referring to Figure 7, the electronic device includes the aforementioned shell assembly 100 configured to define an accommodating space, and a display 200 disposed in the accommodating space. The electronic device has double layer three-dimensional textures, and is able to render a special Moire texture appearance and to render a decoration effect having more dazzle and stereoscopic appearance effect. The electronic device is not liable to deform during long time use, and has a longer service life.

In some embodiments, specific type of the electronic device is not specially limited. The electronic device includes but is not limited to a cell phone, a tablet PC, a wearable device, a game machine, a television, etc. It could be understood that, in addition to the aforementioned shell assembly and the display, the electronic device may further include necessary components and structures of a conventional electronic device. Taking a cell phone as an example, the cell phone may further include a touch-control assembly, a finger-print recognition module, a camera module, a main board, a memory, a battery, etc., which are not described again herein.

Embodiments of the present disclosure will be described in the following.

### Embodiment 1

S1, a three-dimensional glass cover plate with a thickness of approximately 0.6 mm and a refractive index of 1.5 is provided, and a photosensitive acid-resistant film (polyimide film) is sprayed on a front surface and a back surface of the glass cover plate.

S2, a film roll with preset patterns is manufactured by configuring a layout on computer. Then, the film roll with preset patterns and the photosensitive acid-resistant film on the three-dimensional glass cover plate are overlapped with each other, and are further disposed into an exposure machine for exposure. In order to form interference Moire textures, the patterns of the film roll on the front surface and the back surface cannot be completely the same. The front surface and the back surface of the glass cover plate need to be exposed twice, to obtain the exposure areas and the non-exposure areas.

S3, development is performed by a flat spray line, to remove the non-exposure areas of the dry film. The developing liquid is sodium carbonate solution with a mass concentration of 0.5%.

S4, the developed 3D glass plate is immersed into a hydrofluoric-acid etching liquid with a mass concentration of 5% for 2 minutes, and a three-dimensional glass plate with double layer three-dimensional textures in micro/nano level is obtained after the etching. The patterns of the three-dimensional textures correspond to the preset patterns of the film roll. The patterns in front three-dimensional textures include a plurality of parallel strip textures with line widths of 8 microns, line distances of 20 microns, and depths of 5 microns. The patterns in back three-dimensional textures include a plurality of parallel strip textures. The strip textures of the first three-dimensional textures are angled with the strip textures of the second three-dimensional textures at 45 degrees in length direction. The line widths are 8 microns, the line distances are 20 microns, and the depths are 5 microns.

S5, the three-dimensional glass cover plate after etching is taken out, and is further put into water to clean the etching liquid on the glass. The cleaned glass cover is deplated and further cleaned to remove the photosensitive acid-resistant film in the exposure areas. A photo of the obtained three-dimensional glass shell is shown in Figure 8.

### Embodiment 2

S1, a three-dimensional glass cover plate with a thickness of approximately 0.3 mm and a refractive index of 1.5 is provided, and a photosensitive acid-resistant film (polyimide film) is sprayed on a front surface and a back surface of the glass cover plate.

S2, a film roll with preset patterns is manufactured by configuring a layout on computer. Then, the film roll with preset patterns and the photosensitive acid-resistant film on the three-dimensional glass cover plate are overlapped with each other, and are further disposed into an exposure machine for exposure. In order to form interference Moire textures, the patterns of the film roll on the front surface and the back surface cannot be completely the same. The front surface and the back surface of the glass cover plate need to be exposed twice, to obtain the exposure areas and the non-exposure areas.

S3, development is performed by a flat spray line, to remove the non-exposure areas of the dry film. The developing liquid is a sodium carbonate solution with a mass concentration of 0.5%.

S4, the developed 3D glass plate is immersed into a hydrofluoric-acid etching liquid with a mass concentration of 5% for 2 minutes, and a three-dimensional glass plate with double layer three-dimensional textures in micro/nano level is obtained after the etching. The patterns in front three-dimensional textures include a plurality of parallel strip textures with line widths of 8 microns, line distances of 20 microns, and depths of 5 microns. The patterns in back three-dimensional textures include a plurality of parallel strip textures. The strip textures of the first three-dimensional textures are angled with the strip textures of the second three-dimensional textures at 45 degrees in length direction. The line widths are 8 microns, the line distances are 20 microns, and the depths are 5 microns.

S5, the three-dimensional glass cover plate after etching is taken out, and is further put into water to clean the etching liquid on the glass. The cleaned glass cover is deplated and further cleaned to remove the photosensitive acid-resistant film in the exposure areas.

S6, vacuum coating is performed on the back surface of the three-dimensional glass obtained after the operation S5, to form a coating layer with a specific color (with a refractive index of 1.43).

S7, a cover-bottom ink layer is printed on a surface of the coating layer.

### Embodiment 3

S 1, a three-dimensional glass cover plate with a thickness of approximately 0.7mm and a refractive index of 1.5 is provided, and a photosensitive acid-resistant film (liquid crystal polymer film) is sprayed on a front surface and a back surface of the glass cover plate.

S2, a film roll with preset patterns is manufactured by configuring a layout on computer. Then, the film roll with preset patterns and the photosensitive acid-resistant film on the three-dimensional glass cover plate are overlapped with each other, and are further disposed into an exposure machine for exposure. In order to form interference Moire textures, the patterns of the film roll on the front surface and the back surface cannot be completely the same. The front surface and the back surface of the glass cover plate need to be exposed twice, to obtain the exposure areas and the non-exposure areas.

S3, development is performed by a flat spray line, to remove the non-exposure areas of the dry film. The developing liquid is a sodium carbonate solution with a mass concentration of 1%.

S4, the developed 3D glass plate is immersed into a hydrofluoric-acid etching liquid with a mass concentration of 10% for 2 minutes, and a three-dimensional glass plate with double layer three-dimensional textures in micro/nano level is obtained after the etching. The patterns in front three-dimensional textures include a plurality of parallel curve textures with line widths of 50 microns, line distances of 100 microns, and depths of 10 microns. The patterns in back three-dimensional textures include a plurality of parallel curve textures with line widths of 100 microns, line distances of 50 microns, and depths of 20 microns.

S5, the three-dimensional glass cover plate after etching is taken out, and is further put into water to clean the etching liquid on the glass. The cleaned glass cover is deplated and further cleaned to remove the photosensitive acid-resistant film in the exposure areas.

S6, vacuum coating is performed on the back surface of the three-dimensional glass obtained after the operation S5, to form a coating layer with a specific color (with a refractive index of 1.65).

S7, a cover-bottom ink layer is printed on a surface of the coating layer.

### Embodiment 4

S1, a three-dimensional glass cover plate with a thickness of approximately 1 mm and a refractive index of 1.5 is provided, and a photosensitive acid-resistant film (polyethylene naphthalate film) is sprayed on a front surface and a back surface of the glass cover plate.

S2, a film roll with preset patterns is manufactured by configuring a layout on computer. Then, the film roll with preset patterns and the photosensitive acid-resistant film on the three-dimensional glass cover plate are overlapped with each other, and are further disposed into an exposure machine for exposure. In order to form interference Moire textures, the patterns of the film roll on the front surface and the back surface cannot be completely the same. The front surface and the back surface of the glass cover plate need to be exposed twice, to obtain the exposure areas and the non-exposure areas.

S3, development is performed by a flat spray line, to remove the non-exposure areas of the dry film. The developing liquid is a sodium carbonate solution with a mass concentration of 0.8%.

S4, the developed 3D glass plate is immersed into a hydrofluoric-acid etching liquid with a mass concentration of 8% for 2 minutes, and a three-dimensional glass plate with double layer three-dimensional textures in micro/nano level is obtained after the etching. The patterns in front three-dimensional textures include a plurality of dot textures arranged in an array and with line widths (that is, a largest distance between any two dots on a contour of the dot textures) of 20 microns, line distances of 60 microns, and depths of 15 microns. The patterns in back three-dimensional textures include a plurality of parallel strip textures with line widths of 80 microns, line distances of 40 microns, and depths of 30 microns.

S5, the three-dimensional glass cover plate after etching is taken out, and is further put into water to clean the etching liquid on the glass. The cleaned glass cover is deplated and further cleaned to remove the photosensitive acid-resistant film in the exposure areas.

S6, vacuum coating is performed on the back surface of the three-dimensional glass obtained after the operation S5, to form a coating layer with a specific color (with a refractive index of 1.58).

S7, a cover-bottom ink layer is printed on a surface of the coating layer.

### Embodiment 5

S1, a three-dimensional glass cover plate with a thickness of approximately 3mm and a refractive index of 1.5 is provided, and a photosensitive acid-resistant film (polyimide film) is sprayed on a front surface and a back surface of the glass cover plate.

S2, a film roll with preset patterns is manufactured by configuring a layout on computer. Then, the film roll with preset patterns and the photosensitive acid-resistant film on the three-dimensional glass cover plate are overlapped with each other, and are further disposed into an exposure machine for exposure. In order to form interference Moire textures, the patterns of the film roll on the front surface and the back surface cannot be completely the same. The front surface and the back surface of the glass cover plate need to be exposed twice, to obtain the exposure areas and the non-exposure areas.

S3, development is performed by a flat spray line, to remove the non-exposure areas of the dry film. The developing liquid is a sodium carbonate solution with a mass concentration of 0.5%.

S4, the developed 3D glass plate is immersed into a hydrofluoric-acid etching liquid with a mass concentration of 5% for 2 minutes, and a three-dimensional glass plate with double layer three-dimensional textures in micro/nano level is obtained after the etching. The patterns in front three-dimensional textures include a plurality of parallel strip textures with line widths of 8 microns, line distances of 20 microns, and depths of 5 microns. The patterns in back three-dimensional textures include a plurality of parallel strip textures. The strip textures of the first three-dimensional textures are angled with the strip textures of the second three-dimensional textures at 45 degrees in length direction. The line widths are 8 microns, the line distances are 20 microns, and the depths are 5 microns.

S5, the three-dimensional glass cover plate after etching is taken out, and is further put into water to clean the etching liquid on the glass. The cleaned glass cover is deplated and further cleaned to remove the photosensitive acid-resistant film in the exposure areas.

S6, vacuum coating is performed on the back surface of the three-dimensional glass obtained after the operation S5, to form a coating layer with a specific color (with a refractive index of 1.53).

S7, a cover-bottom ink layer is printed on a surface of the coating layer.

### Embodiment 6

S1, a three-dimensional glass cover plate with a thickness of approximately 5mm and a refractive index of 1.5 is provided, and a photosensitive acid-resistant film (polyimide film) is sprayed on a front surface and a back surface of the glass cover plate.

S2, a film roll with preset patterns is manufactured by configuring a layout on computer. Then, the film roll with preset patterns and the photosensitive acid-resistant film on the three-dimensional glass cover plate are overlapped with each other, and are further disposed into an exposure machine for exposure. In order to form interference Moire textures, the patterns of the film roll on the front surface and the back surface cannot be completely the same. The front surface and the back surface of the glass cover plate need to be exposed twice, to obtain the exposure areas and the non-exposure areas.

S3, development is performed by a flat spray line, to remove the non-exposure areas of the dry film. The developing liquid is a sodium carbonate solution with a mass concentration of 0.5%.

S4, the developed 3D glass plate is immersed into a hydrofluoric-acid etching liquid with a mass concentration of 5% for 2 minutes, and a three-dimensional glass plate with double layer three-dimensional textures in micro/nano level is obtained after the etching. The patterns in front three-dimensional textures include a plurality of parallel strip textures with line widths of 100 microns, line distances of 100 microns, and depths of 100 microns. The patterns in back three-dimensional textures include a plurality of parallel strip textures. The strip textures of the first three-dimensional textures are angled with the strip textures of the second three-dimensional textures at 45 degrees in length direction. The line widths are 30 microns, the line distances are 150 microns, and the depths are 100 microns.

S5, the three-dimensional glass cover plate after etching is taken out, and is further put into water to clean the etching liquid on the glass. The cleaned glass cover is deplated and further cleaned to remove the photosensitive acid-resistant film in the exposure areas.

S6, vacuum coating is performed on the back surface of the three-dimensional glass obtained after the operation S5, to form a coating layer with a specific color (with a refractive index of 1.45).

S7, a cover-bottom ink layer is printed on a surface of the coating layer.

### Comparison example 1

Comparison example 1 is similar to the embodiment 2, and the difference is that only the back surface of the glass substrate has textures, and a decoration film is attached to the back surface. The decoration film includes a PET (Polyethylene terephthalate) substrate, and a UV transferring texture layer and a cover-bottom ink layer formed on the PET substrate in sequence.

### Comparison example 2

Comparison example 2 is similar to the embodiment 2, and the difference is that only the back surface of the glass substrate has textures.

### Performance detection:

1. Accelerated aging test: an ultraviolet aging test is performed to the shells obtained in the foregoing embodiments and comparison examples (e.g. referring to ASTMG154). The result shows that the shells of embodiments 1-6 and comparison example 2 have no obvious changes, while the PET substrate in the shell of comparison example 1 is deformed and cracked.
2. Observance of appearances of the shells of the foregoing embodiments and comparison examples: it can be found through observance that the shell in the embodiments 1 to 6 may all render clear and various Moire textures, while the appearance of the Moire textures in the comparison example 1 has poor clarity, and the Moire textures in the comparison example 2 have simple patterns and poor clarity.

In the description of the present disclosure, it is to be understood that, the terms such as "first", "second", and the like, are used herein for purposes of description only, and are not intended to indicate or imply relative importance or significance or to imply the number of indicated technical features. Thus, the feature defined with "first", "second", and the like may include one or more of such a feature. In the description of the present disclosure, "multiple" means two or more, unless otherwise defined expressly.

In the description of the present specification, the description with reference to the terms "one embodiment", "some embodiments", "illustrative embodiment", "example", "specific example", or "some examples", and the like, means that a specific feature, structure, material, or characteristic described in connection with the embodiment or example is included in at least one embodiment or example of the present disclosure. Thus, the illustrative descriptions of the terms throughout this specification are not necessarily referring to the same embodiment or example of the present disclosure. Furthermore, the specific features, structures, materials, or characteristics may be combined in any suitable manner in one or more embodiments or examples. In addition, without contradiction, the skilled person may combine different embodiments or examples and the features of the different embodiments or examples.

Although explanatory embodiments of the present disclosure have been shown and described, it would be appreciated by those skilled in the art that the above embodiments are illustrative, and cannot be construed to limit the present disclosure. Changes, modifications, alternatives, and transformation can be made to the embodiments by those skilled in the art without departing from scope of the present disclosure.

## Claims

1. A shell assembly, comprising:
a glass substrate, wherein the glass substrate comprises a first surface and a second surface opposite to each other, the first surface has first three-dimensional textures in micron level, the second surface has second three-dimensional textures in micron level, and orthographic projections of the first three-dimensional textures in a vertical direction are not fully overlapped with orthographic projections of the second three-dimensional textures in the vertical direction, making lights reflected by the first three-dimensional textures and lights reflected by the second three-dimensional textures interfere with each other.

2. The shell assembly according to claim 1, wherein the first three-dimensional textures and the second three-dimensional textures are recessed toward an inside of the glass substrate.

3. The shell assembly according to claim 1, wherein the first three-dimensional textures are protruded in a direction away from the second surface, and the second three-dimensional textures are recessed toward an inside of the glass substrate.

4. The shell assembly according to any one of claims 1 to 3, wherein at least one of following conditions is satisfied:
line widths of the first three-dimensional textures and line widths of the second three-dimensional textures are in a range of 1-100 microns respectively; or
line distances of the first three-dimensional textures and line distances of the second three-dimensional textures are in a range of 1-150 microns respectively; or
depths of the first three-dimensional textures and depths of the second three-dimensional textures are in a range of 1-100 microns respectively.

5. The shell assembly according to any one of claims 1 to 4, wherein shapes of the orthographic projections of the first three-dimensional textures in the vertical direction and shapes of the orthographic projections of the second three-dimensional textures in the vertical direction are independent from each other, and selected from geometric shapes or irregular shapes, and the geometric shapes comprise at least one of circular shape, polygonal shape, arch shape and multi-arc shape.

6. The shell assembly according to any one of claims 1 to 5, wherein a thickness of the glass substrate is in a range of 0.5-8 mm.

7. The shell assembly according to any one of claims 1 to 6, further comprising:
a coating layer, disposed on the first surface;
a cover-bottom ink layer, disposed on a surface of the coating layer away from the glass substrate.

8. The shell assembly according to any one of claims 1 to 7, wherein the coating layer has a refractive index different from that of the glass substrate.

9. The shell assembly according to claim 8, wherein a difference value between the refractive index of the coating layer and the refractive index of the glass substrate is greater than or equal to 0.5.

10. A preparation method for a shell assembly, comprising:
forming a dry film with preset patterns on two opposite surfaces of a glass, to obtain a to-be-etched glass;
immerging the to-be-etched glass into an etching liquid for a preset time to obtain a glass substrate, wherein the glass substrate comprises a first surface and a second surface opposite to each other, the first surface has first three-dimensional textures in micron level formed by etching, the second surface has second three-dimensional textures in micron level formed by etching, orthographic projections of the first three-dimensional textures in a vertical direction and orthographic projections of the second three-dimensional textures in the vertical direction are not fully overlapped with each other, making lights reflected by the first three-dimensional textures and lights reflected by the second three-dimensional textures interfere with each other; and
removing the dry film from the glass substrate.

11. The method according to claim 10, wherein the forming a dry film with preset patterns on two opposite surfaces of a glass comprises:
providing a whole layer of dry film;
overlapping the whole layer of dry film with a film roll with preset patterns, and exposing and developing them, to obtain exposure areas and non-exposure areas;
removing the dry film in the non-exposure areas, to obtain the dry film with the preset patterns; and
attaching the dry film with the preset patterns on two opposite surfaces of the glass.

12. The method according to claim 10 or 11, wherein the etching liquid is hydrofluoric acid solution with a concentration of 5%-10%, and the preset time is in a range of 1-10 minutes.

13. The method according to any one of claims 10 to 12, wherein the dry film is a photosensitive acid-resistant film.

14. The method according to any one of claims 10 to 13, further comprising:
forming a coating layer on the first surface;
forming a cover-bottom ink layer on a surface of the coating layer away from the glass substrate.

15. An electronic device, comprising:
a shell assembly according to any one of claims 1 to 9, wherein the shell assembly is configured to define an accommodating space; and
a display screen disposed in the accommodating space.
